# EUROPEAN PATENT APPLICATION

(11) **EP 3 951 858 A1**
(43) Date of publication of application: **09.02.2022**
(21) Application number: 20782188.5
(22) Date of filing: 18.03.2020
(51) Int. Cl.: H01L 23/36, H01L 23/373, C08K 5/54, C08K 5/544, C08L 83/06, C08K 3/013

(54) **MULTICOMPONENT TYPE CURABLE ORGANOPOLYSILOXANE COMPOSITION, THERMALLY CONDUCTIVE MEMBER AND HEAT DISSIPATION STRUCTURE**

(30) Priority: 29.03.2019 JP 2019065807
(71) Applicant: Dow Toray Co., Ltd., Tokyo 140-8617 (JP)
(72) Inventor: OTA, Kenji, Ichihara-shi Chiba 299-0108 (JP); FUJISAWA, Toyohiko, Ichihara-shi Chiba 299-0108 (JP); KODAMA, Harumi, Ichihara-shi Chiba 299-0108 (JP)
(74) Representative: Murgitroyd & Company
(86) International application number: PCT/JP2020/011998
(87) International publication number: WO 2020/203297

(57) **Abstract**

[Problem] To provide a curable organopolysiloxane composition having: high thermal conductivity, excellent deep curability under room temperature, excellent adhesion to various base materials, and excellent tight fitting properties to heat dissipating components and the like; a thermally conductive member containing the same; and a heat dissipating structure using the same.

[Resolution Means] A multicomponent curable organopolysiloxane composition containing: a diorganopolysiloxane with a molecular terminal blocked by a hydroxysilyl group; (B) a diorganopolysiloxane with a molecular terminal blocked by an alkoxysilyl group; (C) a thermally conductive filler; (D) an organic silicon compound serving as a surface treating agent of component (C); (E) a component selected from alkylalkoxysilanes and specific adhesionimparting agents; and (F) a catalytic amount of a condensation-reaction catalyst; where at least the following liquid (I) and liquid (II), which are stored separately, are included; as well as a use thereof.

## Description

### TECHNICAL FIELD

The present invention relates to: a curable organopolysiloxane composition having high thermal conductivity, excellent deep curability under room temperature, excellent adhesion to various base materials, and excellent tight fitting properties to heat dissipating components and the like; a thermally conductive member containing the same; and a heat dissipating structure using the same.

### BACKGROUND ART

In recent years, in order to efficiently dissipate the heat generated by electronic and electric equipment, such as electronic components and batteries, along with the high-density and high-integration on printed circuit boards and hybrid ICs on which electronic components, such as transistors, ICs, and memory elements, are mounted, and the increase in the capacity of secondary batteries (cell type), thermally conductive silicone compositions including organopolysiloxane, aluminum oxide powder, zinc oxide powder, and other thermally conductive fillers have been widely used and thermally conductive silicone composition filled with large amounts of thermally conductive filler have been proposed. For example, Patent Document 1 proposes a room temperature moisture thickening type thermally conductive silicone grease composition, where a diorganosiloxane having a hydroxyl group end and a diorganopolysiloxane having an alkoxysilyl group are used in combination. However, such compositions have insufficient curing speed and deep curing at room temperature, and there is still room for improvement with regard to adhesion to various base materials.

In contrast, as a room temperature curable silicone rubber composition which is cured at room temperature upon contacting moisture in the air and exhibits good adhesiveness to the base materials it contacts during curing, the present applicants propose a room temperature curable silicone rubber composition which includes a diorganopolysiloxane having a specific alkoxysilyl group such as a trimethoxysilylethyl containing group, an organopolysiloxane not having this alkoxysilyl group or a hydroxyl group, an alkoxysilane (serving as a crosslinking agent) or a hydrolysate thereof, and a catalyst for a condensation reaction (Patent Document 2). However, the room temperature curable silicone rubber composition according to Patent Document 2 has an insufficient curing speed at room temperature, and there is still room for improvement with regard to adhesion to various base materials. Furthermore, Patent Document 2 does not disclose any thermally conductive silicone composition filled with a large amount of thermally conductive filler in order to cope with a high heat dissipation amount.

### Related Art Documents

### Patent Documents

Patent Document 1: Japanese Unexamined Patent Application 2013-91683
Patent Document 2: Japanese Unexamined Patent Application 2012-219113

### SUMMARY OF THE INVENTION

### PROBLEM TO BE SOLVED BY THE INVENTION

In order to solve the aforementioned problems, an object of the present invention is to provide a multicomponent curable organopolysiloxane composition having high thermal conductivity, excellent precision coating properties and gap-filling properties for electronic components and the like having a large number of gaps such that an entire component after mixing maintains high fluidity even when highly filled with a thermally conductive inorganic filler, and excellent deep curability and adhesion at room temperature. Furthermore, the obtained thermally conductive cured product has excellent curing tight fitting properties, and therefore can prevent damage to the a member by alleviating stress caused by a difference in the rate of thermal expansion between an electronic component and a heat dissipating structure. Furthermore, an object of the present invention is to provide a thermally conductive member using the curable organopolysiloxane composition, and a heat dissipating structure using the member.

### MEANS FOR SOLVING THE PROBLEM

As a result of extensive studies, the present inventors discovered that the aforementioned problem can be solved by a multicomponent organopolysiloxane composition, containing:
(A) 100 parts by weight of a diorganopolysiloxane with a molecular terminal blocked by a hydroxysilyl group and a viscosity at 25°C of 20 to 1,000,000 mPa-s;
(B) 50 to 200 parts by mass of a diorganopolysiloxane with a molecular terminal blocked by an alkoxysilyl group and a viscosity at 25°C of 20 to 1,000,000 mPa-s, with regard to 100 parts by mass of component (A);
(C) 400 to 3,500 parts by mass of a thermally conductive filler;
(D) 0.1 to 2.0 mass% of an organic silicon compound serving as a surface treating agent of component (C), with regard to component (C);
(E) one or more types of components selected from alkylalkoxysilanes and the following components (e1) to (e3):
   (e1) a reaction mixture between an organoalkoxysilane containing an amino group and an organoalkoxysilane containing an epoxy group;
   (e2) an organic compound having at least two alkoxysilyl groups in one molecule, and containing a bond other than a silicon-oxygen bond between the silyl groups; and
   (e3) a silane containing an epoxy group as expressed by general formula:

      R^{a}ₙSi(OR^{b})₄₋ₙ
   (where R^{a} represents an organic group containing a monovalent epoxy group, and R^{b} represents an alkyl group having 1 to 6 carbon atoms, or a hydrogen atom. n represents a number within a range of 1 to 3), or a partially hydrolyzed condensate thereof; and
(F) a catalytic amount of a condensation-reaction catalyst; wherein at least the following liquid (I) and liquid (II), which are stored separately, are included,
   thereby reaching the present invention.
   Note that component (D) and component (E) may be the same or different components, and at least a portion of component (D) and component (E) may be an alkylalkoxysilane.
   Liquid (I): A composition containing component (A) and component (C), where component (D) is optionally selectable and does not contain components (B), (E), and (F)
   Liquid (II): A composition containing components (B), (C), (D), (E), and (F) and does not contain component (A)

In other words, the aforementioned problem can be suitably solved by the following inventions.
[1] A multicomponent organopolysiloxane composition, containing:
   (A) 100 parts by weight of a diorganopolysiloxane with a molecular terminal blocked by a hydroxysilyl group and a viscosity at 25°C of 20 to 1,000,000 mPa-s;
   (B) 50 to 200 parts by mass of a diorganopolysiloxane with a molecular terminal blocked by an alkoxysilyl group and a viscosity at 25°C of 20 to 1,000,000 mPa-s, with regard to 100 parts by mass of component (A);
   (C) 400 to 3,500 parts by mass of a thermally conductive filler;
   (D) 0.1 to 2.0 mass% of an organic silicon compound serving as a surface treating agent of component (C), with regard to component (C);
   (E) one or more types of components selected from alkylalkoxysilanes and the following components (e1) to (e3):
      (e1) a reaction mixture between an organoalkoxysilane containing an amino group and an organoalkoxysilane containing an epoxy group;
      (e2) an organic compound having at least two alkoxysilyl groups in one molecule, and containing a bond other than a silicon-oxygen bond between the silyl groups; and
      (e3) a silane containing an epoxy group as expressed by general formula:

         R^{a}ₙSi(OR^{b})₄₋ₙ
      (where R^{a} represents an organic group containing a monovalent epoxy group, and R^{b} represents an alkyl group having 1 to 6 carbon atoms, or a hydrogen atom. n represents a number within a range of 1 to 3), or a partially hydrolyzed condensate thereof; and
   (F) a catalytic amount of a condensation-reaction catalyst; where at least the following liquid (I) and liquid (II), which are stored separately, are included.
      Liquid (I): A composition containing component (A) and component (C), where component (D) is optionally selectable and does not contain components (B), (E), and (F)
      Liquid (II): A composition containing components (B), (C), (D), (E), and (F) and does not contain component (A)
[2] The curable organopolysiloxane composition according to [1], further containing (G) an aminoalkylmethoxysilane.
[3] The curable organopolysiloxane composition according to any one of [1] to [2], where at least a portion of component (D) is an alkylalkoxysilane.
[4] The curable organopolysiloxane composition according to any one of [1] to [3], where at least a portion of component (D) and component (E) is an alkylalkoxysilane.
[5] The curable organopolysiloxane composition according to any one of [1] to [4], which is curable at room temperature and is cured to form a thermally conductive organopolysiloxane cured product.
[6] A thermally conductive member, containing the curable organopolysiloxane composition according to any one of [1] to [5] or a cured product thereof.
[7] A heat dissipating structure, containing the thermally conductive member according to [6].
[8] A heat dissipating structure, containing a heat dissipating member provided via the curable organopolysiloxane composition according to anyone of [1] to [5] or a cured product thereof on a heat dissipating component or a circuit board on which the heat dissipating component is mounted.
[9] The heat dissipating structure according to [7] or [8], which is an electrical or electronic device.
[10] The heat dissipating structure according to [7] or [8], which is an electrical or electronic component or a secondary battery.

### EFFECTS OF THE INVENTION

The present invention provides a multicomponent curable organopolysiloxane composition having high thermal conductivity, excellent precision coating properties and gap-filling properties for electronic components and the like having a large number of gaps such that the entire composition after mixing maintains high fluidity even when highly filled with a thermally conductive inorganic filler, and excellent deep curability and adhesion at room temperature. Furthermore, the obtained thermally conductive organopolysiloxane cured product has excellent curing tight fitting properties and therefore can prevent damage to a member by alleviating stress caused by a difference in the rate of thermal expansion between an electronic component and a heat dissipating structure. Furthermore, the present invention provides a thermally conductive member using the curable organopolysiloxane composition, and a heat dissipating structure using the member (in particular, a heat dissipating structure of an electric or electronic device, including a heat dissipating structure of an electric or electronic component and a heat dissipating structure of a secondary battery).

### DESCRIPTION OF THE PREFERRED EMBODIMENT

### [Multicomponent Curable Thermally Conductive Organopolysiloxane Composition]

The composition according to the present invention is a curable organopolysiloxane multicomponent curable organopolysiloxane composition containing:
(A) 100 parts by weight of a diorganopolysiloxane with a molecular terminal blocked by a hydroxysilyl group and a viscosity at 25°C of 20 to 1,000,000 mPa-s;
(B) a diorganopolysiloxane with a molecular terminal blocked by an alkoxysilyl group and a viscosity at 25°C of 20 to 1,000,000 mPa-s;
(C) a thermally conductive filler;
(D) an organic silicon compound serving as a surface treating agent of component (C);
(E) an alkylalkoxysilane or other component; and
(F) a condensation-reaction catalyst; where
   at least the following liquid (I) and liquid (II), which are stored separately, are included. Herein, at least a portion of component (D) and component (E) may be the same, or component (D) and component (E) may be different components. In particular, compositions in which at least a portion of component (D) and component (E) are both a decyltrimethoxysilane or other alkylalkoxysilane are preferably included in the scope of the present application.

In the present invention, it is necessary that each composition stored individually does not simultaneously contain component (A) and component (F). This is because when component (A) and component (F) are blended simultaneously, a cross-linking reaction based on a condensation reaction starts spontaneously and the storage stability of the composition is lost in a short period of time, and the long-term storage stability and handleability, which are the objects of multicomponent curable compositions, cannot be realized.

In the present invention, including at least liquid (I) and liquid (II) means that the composition is an individually stored composition and is a multicomponent curable composition made up of a plurality of compositions, including at least two different compositions as defined below, and is not particularly restricted as long as the composition is made up of two or more components stored individually. These components are preferably packaged in a container when stored individually, and are coated or applied after being mixed in a common container at the time of use using a mixer or other mechanical force, or using a dispenser or the like capable of mixing a plurality of components. From the perspective of handleability of the composition and simplicity of mixing operation, the multicomponent curable organopolysiloxane composition of the present invention is preferably a two-component curable organopolysiloxane composition essentially made up of the following liquid (I) and liquid (II).

### [Liquid (I): Composition containing hydroxysilyl-terminated diorganopolysiloxane and thermally conductive filler]

Liquid (I) is a base compound of the present composition, is a composition containing an organopolysiloxane containing an alkenyl group, must be a composition where component is optionally selectable and where components (B), (E), and (F) are not included, and may contain another component.

### [Liquid (II): Composition containing a condensation-reaction catalyst and the like]

Liquid (II) is a composition containing an alkoxysilyl-terminated diorganopolysiloxane, a condensation-reaction catalyst, a surface treating agent, an adhesion promoter, and the like, must be a composition containing the aforementioned components (B) to (F) and not containing component (A), and may optionally contain a portion of component (G) or another component. Note that as described above, at least a portion of components (D) and (E) may be the same component.

The composition of the present invention contains a large amount of thermally conductive filler as an entire composition in order to achieve a high thermal conductivity, and the content of component (C) in these liquid (I) and liquid (II) is preferably in the range of 85 to 98% by mass of the entire respective compositions from the viewpoint of uniformly mixing both liquids. Note that since the liquid (II) contains an organic silicon compound, which is a surface treating agent of component (C), it is possible to suppress separation, to include a large amount of a thermally conductive filler as a whole composition, and to design a composition in which the thermal conductivity of the composition is 2.0 W/mK or more, preferably 3.5 W/mK or more, and more preferably 4.0 W/mK or more.

The multicomponent curable organopolysiloxane composition of the present invention can be designed to contain a large amount of thermally conductive filler, both as the composition as a whole and as each composition, which is the liquid (I) and liquid (II) described above, with no loss of thermal conductivity and handleability of the composition as a whole and achieving excellent deep curability and adhesion and storage stability sufficient for practical use. Furthermore, the curable organopolysiloxane composition according to the present invention can provide a thermally conductive organopolysiloxane cured reaction product, having excellent precision coating and gap-filling properties for electronic components and the like having many gaps because the entire composition after mixing maintains sufficient fluidity for practical use, and having excellent curing tight fitting properties to a member without causing curing defects, particularly in deep portions.

As described above, the multicomponent curable organopolysiloxane composition of the present invention is used by mixing a plurality of individually stored compositions, including liquid (I) and liquid (II), for use thereof. As the mixing method, examples include introducing each component of the multicomponent curable organopolysiloxane composition into a mechanical mixing device (for example, a general-purpose mixer such as a static mixer) using a measuring pump from a storage container and mixed for use or loading of a package of each component into a dispenser enabling squeezing out a certain amount or volume ratio of each component for mixing. Note that when each component of the multicomponent curable organopolysiloxane composition is mixed in an open system mixer, the mixture may be and is preferably used after a de-foaming operation. The liquid (I) and the liquid (II) included in the multicomponent curable organopolysiloxane composition of the present invention have excellent long-term storage stability, do not cause separation problems, and can be uniformly mixed using a simple method, such that handleability is extremely superior.

The components of the multicomponent curable organopolysiloxane composition of the present invention are described below.

### [(A) Diorganopolysiloxane with a molecular terminal blocked by a hydroxysilyl group]

Component (A) is a base compound liquid (I) component of the curable organopolysiloxane composition, and may be a mixture of (A-1) a dioleganopolysiloxane with both ends of a molecular chain blocked by hydroxysilyl groups and (A-2) a dioleganopolysiloxane with only one end of a molecular chain blocked by a hydroxysilyl group, if necessary.

If there are too many (A-2) components in the (A) component, the strength of a silicone elastomer after curing tends to decrease and the adhesion to a substrate tends to decrease.

The mixing ratio thereof is preferably within a range of (A-1):(A-2) = 100:0 to 20:80 based on mass, more preferably within a range of (A-1):(A-2) = 100:0 to 60:40, even more preferably within a range of (A-1):(A-2) = 95:5 to 70:30, and most preferably within a range of (A-1):(A-2) = 95:5 to 80:20.

If the viscosity of component (A) is too low, the strength of the silicone elastomer after curing will be low, and if the viscosity is too high, the composition during manufacture and after mixing will have an excessively high viscosity, which tends to reduce the handleability and gap fill properties of the obtained organopolysiloxane composition.

The viscosity at 25°C is preferably within a range of 20 to 1,000,000 mPa-s, and more preferably within a range of 100 to 200,000 mPa-s. Note that if component (A) is a mixture of components (A-1) and (A-2), the above viscosity is the viscosity as a mixture.

A preferred component (A-1) is a diorganopolysiloxane as expressed by general formula:

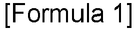

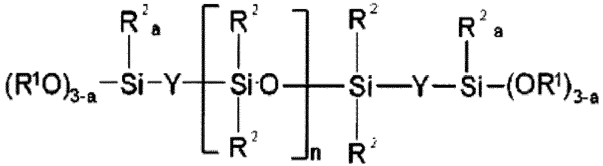

In the formula, R1 represents a hydrogen atom and a represents 2. R2 represents a group selected from monovalent hydrocarbon groups, halogenated hydrocarbon groups, and cyanoalkyl groups. Examples include methyl groups, ethyl groups, propyl groups, butyl groups, octyl groups, and other alkyl groups with 1 to 10 carbon atoms; cyclopentyl groups, cyclohexyl groups, and other cycloalkyl groups; vinyl groups, allyl groups, and other alkenyl groups; phenyl groups, tolyl groups, naphthyl groups, and other aryl groups; benzyl groups, phenylethyl groups, phenylfuropyl groups, and other aralkyl groups; trifluoropropyl groups, chloropropyl groups, and other halogenated hydrocarbon groups; β-cyanoethyl groups, γ-cyanopropyl groups, and other cyanoalkyl groups. Methyl groups are most preferable.

Y represents an oxygen atom, a divalent hydrocarbon group, or a group as expressed by general formula: 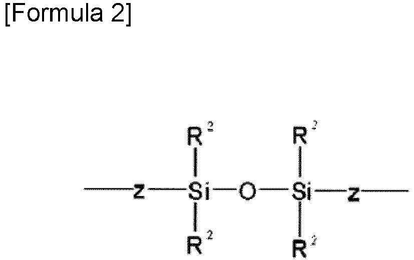 (where R2 represents the same as above and Z represents a divalent hydrocarbon group).

The divalent hydrocarbon group is preferably an alkylene group having 1 to 10 carbon atoms, such as a methylene group, an ethylene group, a propylene group, a butylene group, a hexene group, or the like. n represents a number such that the viscosity at 25°C is 20 to 1,000,000 mPa-s.

Component (A-1) can be manufactured by a well-known method, for example, methods described in Japanese Examined Patent Application Publication No. H3-4566 and Japanese Unexamined Patent Application S63-270762.

Component (A-2) reduces the modulus of a silicone elastomer, which is a cured product of the composition of the present invention, and improves adhesion to a poorly adhesive substrate. A preferred component (A-2) is a diorganopolysiloxane as expressed by general formula:

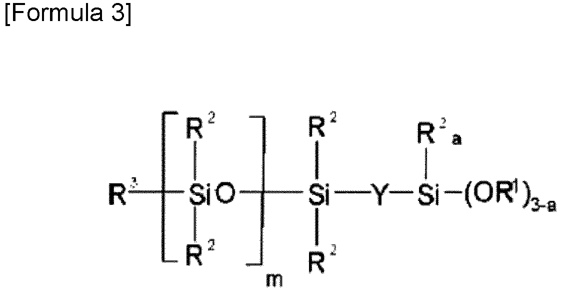

In the formula, R1, R2, Y, and a are the same as described above, and R3 represents a methyl group, an ethyl group, a propyl group, a butyl group, an octyl group, or other alkyl group having 1 to 10 carbon atoms, a vinyl group, an allyl group, or other alkenyl group, preferably an alkyl group having 1 to 10 carbon atoms, and more preferably a methyl group. m represents a number such that the viscosity at 25°C is 20 to 1,000,000 mPa-s.

Component (A-2) can be manufactured by a well-known method, for example, methods described in Japanese Unexamined Patent Application H4-13767 and Japanese Unexamined Patent Application S63-270762.

Note that with regard to these organopolysiloxanes serving as component (A), from the perspective of preventing contact failure and the like, low molecular weight siloxane oligomers (octamethyltetrasiloxane (D4) and decamethylpentasiloxane (D5)) are preferably reduced or eliminated.

### [(B) Diorganopolysiloxane with a molecular terminal blocked by an alkoxysilyl group]

Component (B) is a primary liquid (I) component of the curable organopolysiloxane composition, and may be a mixture of (B-1), a dioleganopolysiloxane with both ends of a molecular chain blocked by alkoxysilyl groups, and (B-2), a dioleganopolysiloxane with only one end of a molecular chain blocked by an alkoxysilyl group, if necessary.

Furthermore, if the viscosity of component (B) is too low, the strength of a silicone elastomer after curing will be low, and if the viscosity is too high, workability during manufacturing and use will be reduced. Therefore, the viscosity at 25°C is preferably within a range of 20 to 1,000,000 mPa-s, and more preferably within a range of 100 to 200,000 mPa-s. Note that if component (B) is a mixture of components (B-1) and (B-2), the above viscosity is the viscosity as a mixture.

A preferred component (B-1) is a diorganopolysiloxane as expressed by general formula:

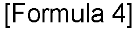

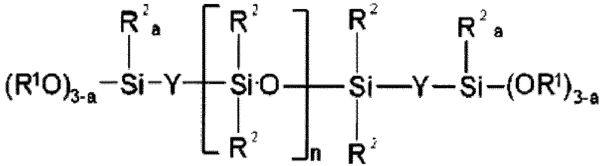

In the formula, R1 represents a group selected from methyl groups, ethyl groups, propyl groups, butyl groups, octyl groups, and other alkyl groups having 1 to 10 carbon atoms, and methoxymethyl groups, methoxyethyl groups, ethoxymethyl groups, ethoxyethoxy groups, and other alkoxyalkyl groups, A methyl group or an ethyl group is preferred. R2 represents a group selected from monovalent hydrocarbon groups, halogenated hydrocarbon groups, and cyanoalkyl groups. Examples include methyl groups, ethyl groups, propyl groups, butyl groups, octyl groups, and other alkyl groups with 1 to 10 carbon atoms; cyclopentyl groups, cyclohexyl groups, and other cycloalkyl groups; vinyl groups, allyl groups, and other alkenyl groups; phenyl groups, tolyl groups, naphthyl groups, and other aryl groups; benzyl groups, phenylethyl groups, phenylfuropyl groups, and other aralkyl groups; trifluoropropyl groups, chloropropyl groups, and other halogenated hydrocarbon groups; β-cyanoethyl groups, γ-cyanopropyl groups, and other cyanoalkyl groups. Methyl groups are most preferable. Note that a represents 0, 1 or 2.

Y represents an oxygen atom, a divalent hydrocarbon group, or a group as expressed by general formula: 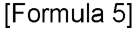 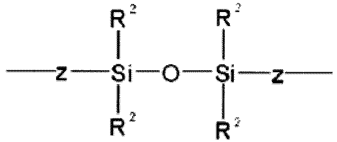 (where R2 represents the same as above and Z represents a divalent hydrocarbon group).

The divalent hydrocarbon group is preferably an alkylene group having 1 to 10 carbon atoms, such as a methylene group, an ethylene group, a propylene group, a butylene group, a hexene group, or the like. n represents a number such that the viscosity at 25°C is 20 to 1,000,000 mPa-s.

Component (B-1) can be manufactured by a well-known method, for example, methods described in Japanese Examined Patent Application Publication No. H3-4566 and Japanese Unexamined Patent Application S63-270762.

Component (B-2) reduces the modulus of a silicone elastomer, which is a cured product of the composition of the present invention, and improves adhesion to a poorly adhesive substrate. A preferred component (B-2) is a diorganopolysiloxane as expressed by general formula:

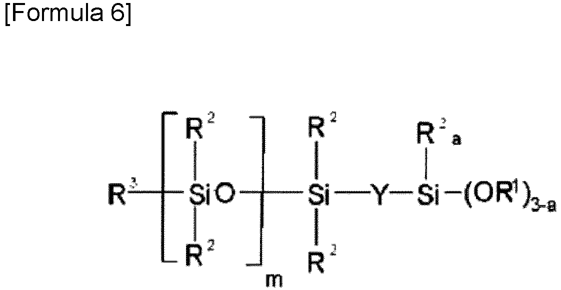

In the formula, R1, R2, Y, and a are the same as described above, and R3 represents a methyl group, an ethyl group, a propyl group, a butyl group, an octyl group, or other alkyl group having 1 to 10 carbon atoms, a vinyl group, an allyl group, or other alkenyl group, preferably an alkyl group having 1 to 10 carbon atoms, and more preferably a methyl group. m represents a number such that the viscosity at 25°C is 20 to 1,000,000 mPa-s.

Component (B-2) can be manufactured by a well-known method, for example, methods described in Japanese Unexamined Patent Application H4-13767 and Japanese Unexamined Patent Application S63-270762.

Note that with regard to these organopolysiloxanes serving as component (B), from the perspective of preventing contact failure and the like, low molecular weight siloxane oligomers (octamethyltetrasiloxane (D4) and decamethylpentasiloxane (D5)) are preferably reduced or eliminated.

### [(C) Thermally conductive filler]

Component (C) is a component common to liquid (I) and liquid (II) described above, and is a thermally conductive filler for imparting thermal conductivity to the composition and a thermally conductive member obtained by curing the composition. Such component (C) is preferably a powder and/or a fiber of at least one or more selected from the group consisting of a pure metal, an alloy, a metal oxide, a metal hydroxide, a metal nitride, a metal carbide, a metal silicide, a carbon, a soft magnetic alloy, and a ferrite. A metallic powder, a metal oxide powder, a metal nitride powder, or carbon powder is preferable.

Such thermally conductive filler is preferably surface treated in whole or in part with alkoxysilane or other surface treating agent, which is component (D) described below. However, when used as a component of liquid (I), the surface treatment does not necessarily have to be performed.

Pure metals include bismuth, lead, tin, antimony, indium, cadmium, zinc, silver, copper, nickel, aluminum, iron and metallic silicon. Alloys include alloys containing two or more metals selected from a group consisting of bismuth, lead, tin, antimony, indium, cadmium, zinc, silver, aluminum, iron and silicon metal. The metal oxides include alumina, zinc oxide, silicon oxide, magnesium oxide, beryllium oxide, chromium oxide and titanium oxide. The metal hydroxides include magnesium hydroxide, aluminum hydroxide, barium hydroxide, and calcium hydroxide. The metal nitrides include boron nitride, aluminum nitride and silicon nitride. The metal carbides include silicon carbide, boron carbide and titanium carbide. The metal silicides include magnesium silicide, titanium silicide, zirconium silicide, tantalum silicide, niobium silicide, chromium silicide, tungsten silicide and molybdenum silicide. The carbon includes diamond, graphite, fullerene, carbon nanotubes, graphene, activated carbon and amorphous carbon black. Soft magnetic alloys include Fe-Si alloys, Fe-AI alloys, Fe-Si-Al alloys, Fe-Si-Cr alloys, Fe-Ni alloys, Fe-Ni-Co alloys, Fe-Ni-Mo alloys, Fe-Co alloy, Fe-Si-Al-Cr alloy, Fe-Si-B alloy, and Fe-Si-Co-B alloy. The ferrites include Mn-Zn ferrite, Mn-Mg-Zn ferrite, Mg-Cu-Zn ferrite, Ni-Zn ferrite, Ni-Cu-Zn ferrite and Cu-Zn ferrite.

Component (C) is suitably silver powder, aluminum powder, aluminum oxide powder, zinc oxide powder, aluminum nitride powder, or graphite. When electrical insulation is required for the present composition, a metal oxide powder or a metal nitride powder is preferable, and in particular, aluminum oxide powder, zinc oxide powder, or aluminum nitride powder is preferable.

The shape of component (C) is not particularly limited, and includes, for example, a spherical shape, a needle shape, a disk shape, a rod shape, and an indefinite shape, and is preferably a spherical shape or an indefinite shape. The average particle diameter of component (D) is not particularly limited, but is preferably in the range of 0.01 to 100 µm, and more preferably in the range of 0.01 to 50 µm.

Component (C) is particularly preferably: (C1) a plate-shaped boron nitride powder having an average particle diameter of 0.1 to 150 µm; (C2) a granular or spherically compacted boron nitride powder having an average particle diameter of 0.1 to 500 µm; (C3) a spherical melt-solidified and/or crushed aluminum oxide powder having an average particle diameter of 0.01 to 50 µm; or (C4) spherical and/or crushed graphite having an average particle diameter of 0.01 to 50 µm, or a mixture of two or more of these. A mixture of two or more types of spherical and crushed aluminum oxide powders having an average particle diameter of 0.01 to 50 µm is most preferable. In particular, the combination of aluminum oxide powders with large particle size and small particle size in the ratio following the maximum packing theoretical distribution curve improves the packing efficiency and enables low viscosity and high thermal conductivity.

The content of component (C) is within a range of 400 to 3,500 parts by mass for 100 parts by mass of component (A) in the entire composition for each of liquid (I) and liquid (II), and preferably within a range of 600 to 3,000 parts by mass. That is, as an entire composition, the sum of the components (D) in liquid (I) and liquid (II) is within a range of 800 to 7000 parts by mass, and said sum may be within a range of 1200 to 6000 parts by mass, and may be within a range of 2400 to 5500 parts by mass. This is because, if the content of component (C) is less than the lower limit of the above range, the thermal conductivity of the resulting composition will be less than 2.0 W/mK while, if the content of component (D) exceeds the upper limit of the above range, even when component (C) is blended or used for surface treatment of component (D), the viscosity of the resulting composition is remarkably high, and the handleability, gap fill properties, and the like are reduced.

The composition of the present invention preferably has a thermal conductivity of 2.0 W/mK or more, and the content of component (C) is preferably within a range of 85 to 98% by mass of the entire composition, and more preferably within a range of 87 to 95% by mass. If within the range described above, a thermally conductive curable organopolysiloxane composition can be designed that achieves a thermal conductivity of 2.0 W/mK or more, preferably 3.5 W/mK or more, more preferably 4.0 W/mK or more, and particularly preferably 5.0 W/mK or more, while maintaining excellent gap fill properties and flowability, which are objects of the present invention.

### [Other Inorganic Fillers]

The composition of the present invention contains, as optional ingredients, inorganic fillers such as fumed silica, wet-produced silica, crushed quartz, titanium oxide, magnesium carbonate, zinc oxide, iron oxide, kieselguhr, carbon black, and the like, and blending in of inorganic fillers in which the surface of such inorganic fillers is hydrophobically treated with organic silicon compounds (silazanes, and the like) does not fully inhibit; however, from the perspective of achieving both high thermal conductivity and high gap fill properties, filler other than component (D) is preferably essentially not contained. In particular, when reinforcing fillers having a broad BET specific surface area, such as reinforcing silicas, are blended into the present composition, achieving the rheological properties characteristic of the present invention by blending into the composition an amount of component (C) that imparts a thermal conductivity of 3.5 W/mK or more may be difficult. The term "essentially does not include" means that the content of the filler other than the component (C) in the composition is preferably less than 1% by mass, and more preferably less than 0.5% by mass. Note that most preferably, the intentional addition of a filler other than component (C) is 0.0% by mass in the composition.

### [Surface Treatment of Component (C)]

The present composition contains an organic silicon compound, which is a surface treating agent of component (C), within a range of 0.1 to 2.0% by mass when the entire component (C) of the present invention is 100 mass%, and component (C) is preferably surface treated by these components. Although a surface treating process of component (C) is arbitrary, from the perspective of achieving practical fluidity and gap-filling properties in the present composition, a preferred example of the process is a process in which at least a portion of component (C) is surface treated, in particular by component (D).

### [(D) Organic Silicon Compound Serving as a Surface Treating Agent of Component (C)]

Component (D) is a surface treating agent of component (C), and is a component that improves the amount of component (C) and improves the viscosity and fluidity of the entire composition, such that the composition as a whole can achieve sufficient fluidity and gap-filling properties for practical use. A known organic silicon compound can be used for such component (D) without any particular limitation, but component (D1) an alkoxysilane having an alkyl group having six or more carbon atoms in the molecule, as described below, is in particular suitably included. Note that as described above, at least a portion of component (D) and component (E) may be and is preferably an alkylalkoxysilane. In other words, alkylalkoxysilanes, such as alkyltrialkoxysilanes and the like, are components that can be used both as component (D) and as a portion or all of component (E), and embodiments in which component (D) and component (E) are both alkylalkoxysilanes are encompassed by preferred forms of the present invention.

Examples of organic silicon compounds include low molecular weight organic silicon compounds such as silanes, silazanes, siloxanes, and the like, and organic silicon polymers or oligomers such as polysiloxanes, polycarbosiloxanes, and the like. A so-called silane coupling agent is an example of a preferred silane. Typical examples of the silane coupling agents include alkyltrialkoxysilanes (such as methyltrimethoxysilane, vinyltrimethoxysilane, hexyltrimethoxysilane, octyltrimethoxysilane, and decyltrimethoxysilane, and the like) and trialkoxysilanes containing an organic functional group (such as glycidoxypropyltrimethoxysilane, epoxycyclohexyl ethyltrimethoxysilane, methacryloxypropyltrimethoxysilane, aminopropyltrimethoxysilane, and the like). Preferred siloxanes and polysiloxanes include hexamethyldisiloxanes, 1,3-dihexyl-tetramethyldisiloxanes, trialkoxysilyl single-terminated polydimethylsiloxanes, trialkoxysilyl single-terminated dimethylvinyl single-terminated polydimethylsiloxanes, trialkoxysilyl single-terminated organic functional group single-terminated polydimethylsiloxanes, trialkoxysilyl doubly-terminated polydimethylsiloxanes, organic functional group doubly-terminated polydimethylsiloxanes, and the like. When a siloxane is used, the number n of siloxane bonds is preferably within a range of 2 to 150. Examples of preferred silazanes include hexamethyldisilazanes, 1,3-dihexyl-tetramethyldisilazanes, and the like. A polymer having an Si-C-C-Si bond in a polymer main chain is an example of a preferred polycarbosiloxane.

The silane coupling agent serving as component (D) is expressed by general formula:

R¹_{(4-c)}Si(OR²)_{c}

In the formula, R¹ represents a monovalent hydrocarbon group, an organic group containing an epoxy group, an organic group containing a methacryl, or an organic group containing an acrylic group. Examples of the monovalent hydrocarbon group of R¹ include straight-chain alkyl groups such as methyl groups, ethyl groups, propyl groups, butyl groups, hexyl groups, decyl groups, and the like; branched-chain alkyl groups such as isopropyl groups, tertiary butyl groups, isobutyl groups, and the like; cyclic alkyl groups such as cyclohexyl groups and the like; alkenyl groups such as vinyl groups, allyl groups, butenyl groups, pentenyl groups, hexenyl groups, heptenyl groups, and the like; aryl groups such as phenyl groups, tolyl groups, xylyl groups, and the like; aralkyl groups such as benzyl groups, phenethyl groups, and the like; halogenated alkyl group such as 3,3,3-trifluoropropyl groups, 3-chloropropyl groups, and the like; and other substituted or unsubstituted monovalent hydrocarbon groups. Examples of the organic group containing an epoxy group of R4 include glycidoxyalkyl groups such as 3-glycidoxypropyl groups and 4-glycidoxybutyl groups; epoxycyclohexyl alkyl groups such as 2-(3,4-epoxycyclohexyl) ethyl groups, 3-(3,4-epoxycyclohexyl)propyl groups; and the like. Furthermore, examples of R¹ organic groups containing a methacryl include methacryloxyalkyl groups such as 3-methacryloxypropyl groups, 4-methacryloxybutyl groups, and the like. Furthermore, examples of the organic group containing an acrylic group of R¹ include acryloxyalkyl groups such as 3-acryloxypropyl groups, 4-acryloxysibutyl groups, and the like.

R² represents an alkyl group, an alkoxyalkyl group, an alkenyl group, or an acyl group. Examples of the alkyl group of R² include straight-chain alkyl groups, branched-chain alkyl groups, and cyclic alkyl groups as described above; as the alkoxyalkyl group of R², examples include methoxyethyl groups and methoxypropyl groups; as the alkenyl group of R², examples include vinyl groups, allyl groups, butenyl groups, pentenyl groups, and hexenyl groups; and as the acyl group of R², examples include acetyl groups and octanoyl groups.

c represents an integer from 1 to 3, and is preferably 3.

Other than component (D1), examples of component (D) include methyltrimethoxysilane, methyltriethoxysilane, ethyltrimethoxysilane, n-propyltrimethoxysilane, butyltrimethoxysilane, pentyltrimethoxysilane vinyltrimethoxysilane, vinyltriethoxysilane, methylvinyldimethoxysilane, allyltrimethoxysilane, allylmethyldimethoxysilane, butenyltrimethoxysilane, 3-glycidoxypropyltrimethoxysilane, 3-glycidoxypropylmethyldimethoxysilane, 3-glycidoxypropyltriethoxysilane, 3-methacryloxypropyltrimethoxysilane, 3-Methacryloxypropyltriethoxysilane, 3-Methacryloxypropylmethyldimethoxysilane, 3-Acryloxypropyltrimethoxysilane, and 3-Acryloxypropylmethyldimethoxysilane.

### [(D1) Alkylalkoxysilane]

Component (D1) is a preferred component in the present composition, and is an alkoxysilane having an alkyl group with 6 or more carbon atoms in a molecule. Herein, specific examples of the alkyl group having 6 or more carbon atoms include alkyl groups such as hexyl groups, octyl groups, dodecyl groups, tetradecyl groups, hexadecyl groups, and octadecyl groups; and aralkyl groups such as benzyl groups and phenylethyl groups. An alkyl group having 6 to 20 carbon atoms is particularly preferred. In the case of an alkoxysilane having an alkyl group with less than 6 carbon atoms, an effect of reducing the viscosity of the composition is insufficient, and the viscosity of the composition may increase causing a desired fluidity and gap-filling properties to not be achieved. Furthermore, when an alkoxysilane having an alkyl group with 20 or more carbon atoms or the like is used, the industrial supply-ability thereof is inferior and, depending on the type of component (A), miscibility may be reduced.

Preferably, component (D1) is an alkoxysilane represented by the structural formula:

YₙSi(OR)₄₋ₙ

(In the formula, Y is an alkyl group having 6 to 18 carbon atoms, R is an alkyl group having 1 to 5 carbon atoms, and n is a number of 1 or 2), and examples of the OR group include a methoxy group, an ethoxy group, a propoxy group, a butoxy group and the like, and a methoxy group, and an ethoxy group are particularly preferred.

The n represents 1, 2 or 3, and is particularly preferably 1.

Specific examples of such component (E1) include C₆H₁₃Si(OCH₃)₃, C₈H₁₇Si(OC₂H₅)₃, C₁₀H₂₁Si (OCH₃)₃, C₁₁H₂₃Si(OCH₃)₃, C₁₂H₂₅Si(OCH₃)₃, C₁₄H₂₉Si(OC₂H₅)₃, and the like, and most preferably a decyltrimethoxysilane.

### [(D2) Polysiloxane-Type Surface Treating Agent Having a Hydrolyzable Silyl Group at One End of a Molecular Chain]

Component (D2) is a surface treating agent having a hydrolyzable silyl group at one end of a molecular chain and having a polysiloxane structure. Component (C) is preferably surface-treated by component (D), and then even if a large amount of the thermally conductive filler, which is component (C), is blended by performing a surface treatment by component (D2), it may be possible to provide a multicomponent curable organopolysiloxane composition in which the composition before curing has practically sufficient fluidity and gap fill properties without impairing the deep curability and adhesion of the composition.

Specifically, component (D2) is an organopolysiloxane having a hydrolyzable silyl group at an end of a molecular chain, and although the structure is not particularly limited, such component (F) is an organopolysiloxane as expressed by the following general formula (1) or general formula (2), or a mixture thereof.
(i) An organopolysiloxane as expressed by general formula (1):

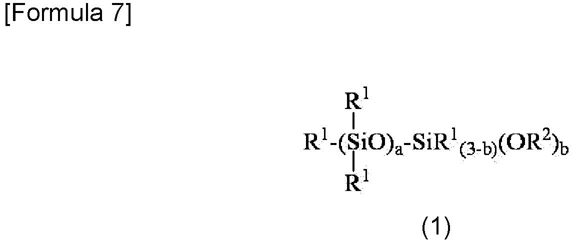

(In the formula, R¹ represent independent unsubstituted or substituted monovalent hydrocarbon groups, and R² represent independent hydrogen atoms, alkyl groups, alkoxyalkyl groups, alkenyl groups, or acyl groups, a represents an integer from 5 to 250, and b represents an integer from 1 to 3), with a viscosity of 10 to less than 10,000 mP-s at 25°C.

### [(E) Component That Functions as a Cross-Linking Agent or Adhesion Promoter]

Component (E) is a component that functions as a cross-linking agent or adhesion promoter, and is one or more type selected from an alkyl alkoxysilane, such as the alkyltrialkoxysilanes described as component (D) (methyltrimethoxysilane, vinyltrimethoxysilane, hexyltrimethoxysilane, octyltrimethoxysilane, decyltrimethoxysilane, or the like) and the following components (e1) to (e3), which further improve the adhesive durability and adhesive strength even when used in a harsh environment, and enables the reliability and durability of electrical and electronic components to be maintained over a long period of time.
(e1) a reaction mixture between an organoalkoxysilane containing an amino group and an organoalkoxysilane containing an epoxy group;
(e2) an organic compound having at least two alkoxysilyl groups in one molecule, and containing a bond other than a silicon-oxygen bond between the silyl groups; and
(e3) a silane containing an epoxy group as expressed by general formula:

   R^{a}ₙSi(OR^{b})₄₋ₙ

   (where R^{a} represents an organic group containing a monovalent epoxy group, and R^{b} represents an alkyl group having 1 to 6 carbon atoms, or a hydrogen atom. n represents a number within a range of 1 to 3), or a partially hydrolyzed condensate thereof

Component (e1) is a reaction mixture between an amino group-containing organoalkoxysilane and an epoxy group-containing organoalkoxysilane. Such component (e1) is a component for imparting initial adhesiveness to various base materials it contacts during curing, in addition to imparting adhesiveness at low temperatures particularly to an uncleaned adherend. Moreover, some curing systems of a curable composition obtained by blending this adhesion promoter may act as a crosslinking agent. Such a reaction mixture is disclosed in JP 52-8854 B and JP 10-195085 A.

Exemplary alkoxysilanes having an amino group-containing organic group forming such component (e1) include an aminomethyltriethoxysilane, 3-aminopropyltrimethoxysilane, 3-aminopropyltriethoxysilane, 3-aminopropylmethyldimethoxysilane, N-(2-aminoethyl)aminomethyltributoxysilane, N-(2-aminoethyl)-3-aminopropyltrimethoxysilane, N-(2-aminoethyl)-3-aminopropylmethyldimethoxysilane, and 3-anilinopropyltriethoxysilane.

Moreover, exemplary epoxy groups containing organoalkoxysilanes may include 3-glycidoxyprolyltrimethoxysilane, 3-glycidoxypropylmethyldimethoxysilane, 2-(3,4-epoxy cyclohexyl)ethyltrimethoxysilane, and 2-(3,4-epoxy cyclohexyl)ethylmethyldimethoxysilane.

The ratio of the alkoxysilane having an amino group containing organic group to the alkoxysilane having an epoxy group containing organic group is, in terms of the molar ratio, preferably within the range of (1:1.5) to (1:5), particularly preferably within the range of (1:2) to (1:4). This component (e1) can be easily synthesized by mixing alkoxysilane having an amino group containing organic group and alkoxysilane having an epoxy group containing organic group as mentioned above to cause them to react at room temperature or under heating.

In particular, when an alkoxysilane having an amino group containing organic group is reacted with an alkoxysilane having an epoxy group containing organic group by the method described in JP 10-195085 A, the present invention particularly preferably contains a carbasilatrane derivative obtained by cyclizing and represented by the general formula: 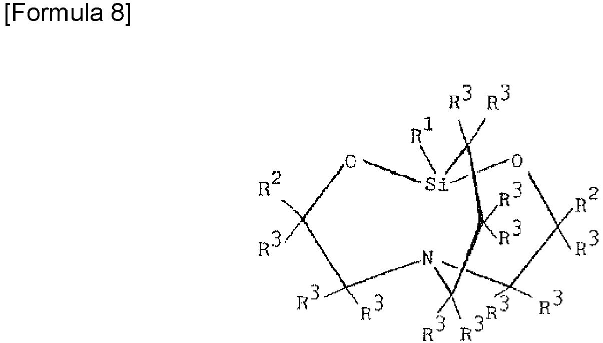 {wherein, R¹ is an alkyl group or an alkoxy group, and R² is the same or different group selected from the group consisting of groups represented by the general formula: 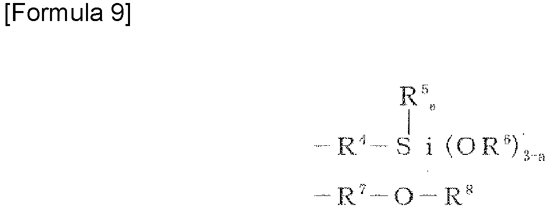 (wherein, R⁴ is an alkylene group or alkyleneoxyalkylene group, R⁵ is a monovalent hydrocarbon group, R⁶ is an alkyl group, R⁷ is an alkylene group,
R⁸ is an alkyl group, alkenyl group, or acyl group, and a is 0, 1, or 2.)
R³ is the same or different hydrogen atom or alkyl group.}

Exemplary carbasilatrane derivatives may include a silatrane derivative having an alkenyl group and silicon atom-bonded alkoxy group per one molecule represented by the following structure.

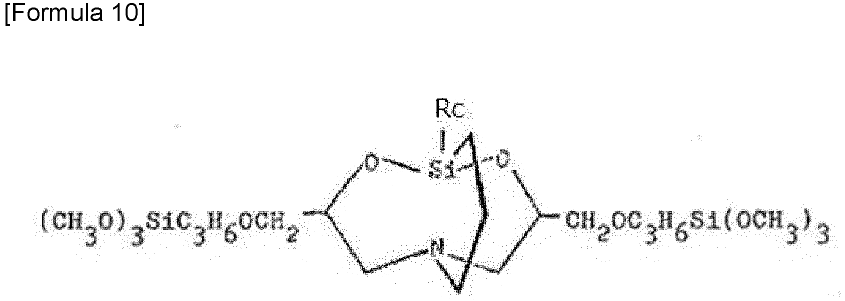

(where Rc is a group selected from methoxy groups, ethoxy groups, vinyl groups, allyl groups and hexenyl groups) Similarly, with the present invention, the silatrane derivative expressed by the following structural formula can be used. 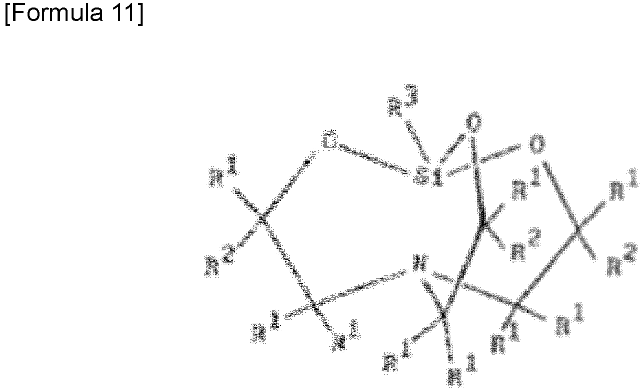
R¹ in the formula is the same or different hydrogen atom or an alkyl group, and
R¹ is particularly preferably a hydrogen atom or a methyl group. Furthermore,
R² in the aforementioned formula is the same or different group selected from a group consisting of a hydrogen atom, alkyl groups, and organic group containing an alkoxysilyl group as expressed by the general formula:

   -R⁴-Si(OR⁵)ₓR⁶₍₃₋ₓ₎
where at least one of the R²s is the organic group containing an alkoxysilyl group. Examples of the alkyl group of R² include methyl groups and the like. Furthermore, in the organic group containing an alkoxysilyl group of R², R⁴ in the formula is a divalent organic group, and examples include alkylene groups or alkyleneoxyalkylene groups. An ethylene group, a propylene group, a butylene group, a methyleneoxypropylene group, and a methyleneoxypentylene group are particularly preferable. Furthermore, R⁵ in the formula is an alkyl group having 1 to 10 carbon atoms, and preferably a methyl group or an ethyl group. Furthermore, R⁶ in the formula is a substituted or unsubstituted monovalent hydrocarbon group, and preferably a methyl group. Furthermore, x in the formula is 1, 2, or 3, and preferably 3.

Examples of such an organic group containing an alkoxysilyl group of R² include the following groups.
- (CH2)2Si(OCH3)3-(CH2)2Si(OCH3)2CH3
- (CH2)3Si(OC2H5)3-(CH2)3Si(OC2H5)(CH3)2
- CH2O(CH2)3Si(OCH3)3
- CH2O(CH2)3Si(OC2H5)3
- CH2O(CH2)3Si(OCH3)2CH3
- CH2O(CH2)3Si(OC2H5)2CH3
- CH2OCH2Si(OCH3)3-CH2OCH2Si(OCH3)(CH3)2

R³ in the above formula is at least one group selected from a group consisting of substituted or unsubstituted monovalent hydrocarbon groups, alkoxy groups having 1 to 10 carbon atoms, glycidoxyalkyl groups, oxiranylalkyl groups, and acyloxyalkyl groups. Examples of the monovalent hydrocarbon group of R³ include methyl groups and other alkyl groups. Examples of the alkoxy group of R³ include methoxy groups, ethoxy groups, and propoxy groups. Examples of the glycidoxyalkyl group of R³ include 3-glycidoxypropyl groups. Examples of the oxiranylalkyl group of R³ include 4-oxiranylbutyl groups and 8-oxiranyl octyl groups. Examples of the acyloxyalkyl group of R³ include acetoxypropyl groups and 3-methacryloxypropyl groups. In particular, R³ is preferably an alkyl group, an alkenyl group, or an alkoxy group, and more preferably an alkyl group or an alkenyl group. Particularly preferred examples include groups selected from methyl groups, vinyl groups, allyl groups, and hexenyl groups.

Component (e2) is an organic compound having at least two alkoxysilyl groups per one molecule, in addition to containing bonds other than a silicon-oxygen bond between these silyl groups, and serves to independently improve initial adhesiveness and improve the adhesive durability to a cured product including this adhesion promoter under harsh conditions particularly when used in combination with components (e1) and (e3).

In particular, component (e2) is preferably a disilaalkane compound as expressed by the following general formula: 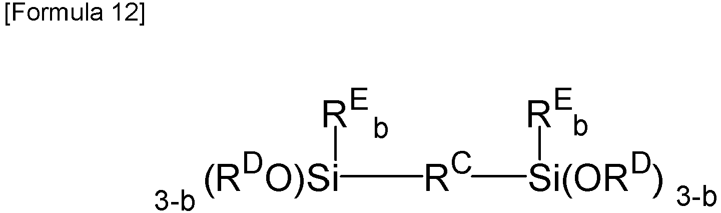 (where R^{C} represents a substituted or unsubstituted alkylene group having a carbon number of 2 to 20, R^{D} is each independently an alkyl group or alkoxyalkyl group, R^{E} is each independently a monovalent hydrocarbon group, and b is each independently 0 or 1.)

Such component (e2) is commercially available as a reagent or product in various compounds and can be synthesized using a well-known method such as the Grignard reaction or hydrosilylation reaction. For example, component (g2) can be synthesized via a well-known method by the hydrosilylation reaction between diene and trialkoxysilane or organodialkoxysilane.

In the formula, R^{E} is a monovalent hydrocarbon group including: an alkyl group such as a methyl group, ethyl group, and propyl group; an alkenyl group such as a vinyl group or allyl group; and an aryl group such as a phenyl group, with a lower alkyl group preferable. R^{D} is an alkyl group such as a methyl group, ethyl group, and propyl group, or an alkoxyalkyl group such as a methoxyethyl group, preferably having a carbon number of 4 or less. R^{C} is a substituted or unsubstituted alkylene group, with a linear or branched alkylene group used without limitation, and may be a mixture thereof. In terms of improving adhesiveness, a linear and/or branched alkylene group having a carbon number of 2 to 20 is preferable, with a linear and/or branched alkylene having a carbon number of 5 to 10, particularly hexylene having a carbon number of 6, is preferable. The unsubstituted alkylene group may be a butylene group, pentylene group, hexylene group, heptylene group, octylene group, nonylene group, decylene group, or a branched structure thereof, with the hydrogen atom capable of being substituted with a methyl group, ethyl group, propyl group, butyl group, cyclopentyl group, cyclohexyl group, vinyl group, allyl group, 3,3,3-trifluoropropyl group, or 3-chloropropyl group.

Specific examples of component (e2) include bis(trimethoxysilyl)ethane, 1,2-bis(trimethoxysilyl)ethane, 1,2-bis(triethoxysilyl)ethane, 1,2-bis(methyldimethoxysilyl)ethane, 1,2-bis(methyldiethoxysilyl)ethane, 1,1-bis(trimethoxysilyl)ethane, 1,4-bis(trimethoxysilyl)butane, 1,4-bis(triethoxysilyl)butane, 1-methyldimethoxysilyl-4-trimethoxysilylbutane, 1-methyldiethoxysilyl-4-triethoxysilylbutane, 1,4-bis(methyldimethoxysilyl)butane, 1,4-bis(methyldiethoxysilyl)butane, 1,5-bis(trimethoxysilyl)pentane, 1,5-bis(triethoxysilyl)pentane, 1,4-bis(trimethoxysilyl)pentane, 1,4-bis(triethoxysilyl)pentane, 1-methyldimethoxysilyl-5-trimethoxysilylpentane, 1-methyldiethoxysilyl-5-triethoxysilylpentane, 1,5-bis(methyldimethoxysilyl)pentane, 1,5-bis(methyldiethoxysilyl)pentane, 1,6-bis(trimethoxysilyl)hexane, 1,6-bis(triethoxysilyl)hexane, 1,4-bis(trimethoxysilyl)hexane, 1,5-bis(trimethoxysilyl)hexane, 2,5-bis(trimethoxysilyl)hexane, 1-methyldimethoxysilyl-6-trimethoxysilylhexane, 1-phenyldiethoxysilyl-6-triethoxysilylhexane, 1,6-bis(methyldimethoxysilyl)hexane, 1,7-bis(trimethoxysilyl)heptane, 2,5-bis(trimethoxysilyl)heptane, 2,6-bis(trimethoxysilyl)heptane, 1,8-bis(trimethoxysilyl)octane, 2,5-bis(trimethoxysilyl)octane, 2,7-bis(trimethoxysilyl)octane, 1,9-bis(trimethoxysilyl)nonane, 2,7-bis(trimethoxysilyl)nonane, 1,10-bis(trimethoxysilyl)decane, and 3,8-bis(trimethoxysilyl)decane. These can be used independently or as a mixture of two or more types thereof. In the present invention, 1,6-bis(trimethoxysilyl)hexane, 1,6-bis(triethoxysilyl)hexane, 1,4-bis(trimethoxysilyl)hexane, 1,5-bis(trimethoxysilyl)hexane, 2,5-bis(trimethoxysilyl)hexane, 1-methyldimethoxysilyl-6-trimethoxysilylhexane, 1-phenyldiethoxysilyl-6-triethoxysilylhexane, and 1,6-bis(methyldimethoxysilyl)hexane can be suitably exemplified.

Component (e3) is a silane containing an epoxy group as expressed by the general formula:

R^{a}ₙSi(OR^{b})₄₋ₙ

(where R^{a} represents an organic group containing a monovalent epoxy group, R^{b} represents an alkyl group having a carbon number of 1 to 6, or a hydrogen atom. n represent a number within a range of 1 to 3) or a partially hydrolyzed condensate thereof, independently improves initial adhesiveness, and particularly enhances the adhesive durability under harsh conditions such as salt water immersion in a cured product including this adhesion promoter in combination with said components (e1) and (e2).

Note that component (e3) is one of the constituent components of component (e1), (wherein, the mass ratio with reactant component (e1) (typically, a carbasilatrane derivative serving as a cyclized reactant) within the specific range is necessary in terms of the technical effects of the invention) and must be added as a component separate from component (e1).

Exemplary epoxy group containing silanes may include 3-glycidoxyprolyltrimethoxysilane, 3-glycidoxypropylmethyldimethoxysilane, 2-(3,4-epoxy cyclohexyl)ethyltrimethoxysilane, and 2-(3,4-epoxy cyclohexyl)ethylmethyldimethoxysilane.

While the blended amount of component (E) is not particularly limited, from the perspective of functioning as an adhesion promoter or cross-linking agent, the mass of component (E) may be within a range of 0.5 to 20 mass% in the curable organopolysiloxane composition, preferably 1.0 to 10 mass%, particularly preferably 1.0 to 5.0 mass%.

As mentioned above, if component (E) is an alkylalkoxysilane, it can also function as a surface treatment agent, which is component (D). When both component (D) and component (E) contain an alkylalkoxysilane in this composition, the alkylalkoxysilane may be added as component (D) in a different process that the surface treatment of component (C), or the alkylalkoxysilane may be blended in a larger amount than used as the surface treatment agent.

### [(F) Condensation-Reaction Catalyst]

When component (F) is used in combination with component (B) or the like, the curability of the composition according to the present invention in warming at from room temperature to 50°C, as well as the adhesiveness to various base materials can be improved. Specifically, component (F) is the catalyst amount of a catalyst for a condensation reaction, promoting and curing for the intention to the condensation reaction of the organopolysiloxane. Examples of component (F) include tin compounds such as dimethyltin dineodecanoate and stannous octoate; and titanium compounds such as tetra(isopropoxy)titanium, tetra(n-butoxy)titanium, tetra(t-butoxy)titanium, di(isopropoxy)bis(ethylacetoacetate)titanium, di(isopropoxy)bis(methylacetoacetate)titanium, di(isopropoxy)bis(acetylacetonate)titanium, and the like. The amount used is a catalyst amount, can be appropriately selected in accordance with the desired curing conditions, and is generally within the range of 0.01 to 5 parts by mass with respect to 100 parts by mass of the total of the organopolysiloxane in the overall composition.

### [(G): Aminoalkylmethoxysilane]

Examples of aminoalkylmethoxysilanes include an aminomethyltriethoxysilane, 3-aminopropyltrimethoxysilane, 3-aminopropyltriethoxysilane, 3-aminopropylmethyldimethoxysilane, N-(2-aminoethyl)aminomethyltributoxysilane, N-(2-aminoethyl)-3-aminopropyltrimethoxysilane, N-(2-aminoethyl)-3-aminopropylmethyldimethoxysilane, and 3-anilinopropyltriethoxysilane.

### [Optional Heat Resistance-Imparting Agent]

From the viewpoint of improving the heat resistance of the multi-component curable organopolysiloxane composition and the cured product thereof after mixing, it is preferred that the composition of the present invention further contains a heat resistance-imparting agent. Note that this component may be blended in one of either liquid (I) or liquid (II), or may be added as one independent component when the composition is designed to have three or more components. This component is not particularly limited as long as the component is capable of imparting heat resistance to the composition according to the present invention and the cured product thereof, with examples thereof including: metal oxides such as iron oxide, titanium oxide, cerium oxide, magnesium oxide, and zinc oxide; metal hydroxides such as cerium hydroxide; phthalocyanine compounds; cerium silanolate; cerium fatty acid salts; reaction products of an organopolysiloxane with a cerium carboxylic acid salt; etc. Particularly suitably, component (G) is a phthalocyanine compound, for example, an additive selected from the group consisting of a metal-free phthalocyanine compound and a metal-containing phthalocyanine compound disclosed in JP 2014-503680 W is suitably used, with copper phthalocyanine compounds particularly suitable among the metal-containing phthalocyanine compounds. One example of the most suitable and nonlimiting heat resistance imparting agent is 29 H,31H-phthalocyaninato(2-)-N29,N30,N31,N32 copper. Such phthalocyanine compounds are commercially available, for example, Stan-tone (trademark) 40SP03 from PolyOne Corporation (Avon Lake, Ohio, USA.)

The blended amount of the heat resistance-imparting agent may be within a range of 0.01 to 5.0% by mass of the total composition, or may be within a range of 0.05 to 0.2 mass%, or 0.07 to 0.1 mass% thereof.

### [Other additives]

In addition to the above mentioned components, optional components may be added to the multi-component curable organopolysiloxane composition of the present invention, so long as the object of the present invention is not impaired. The optional components include, for example, cold resistance imparting agents, flame retardance imparting agents, pigments, dyes, and the like. Moreover, the multi-component curable organopolysiloxane composition of the present invention can, if desired, include one or more type of antistatic agents including adhesion imparting agents, cationic surfactants, anionic surfactants, or nonionic surfactants, dielectric fillers, electrically conductive fillers, mold release components, thixotropy imparting agents, antifungal agents, and the like. If desired, an organic solvent may be added. These additives may be blended in either of liquids selected from liquid (I) and liquid (II), or may be added as one independent component when this composition is designed to have three or more components.

The composition may also contain other optional components, as long as the purpose of the invention is not impaired, and examples include non-reinforcing fillers such as quartz fine powder, calcium carbonate fine powder, diatomaceous earth fine powder, aluminum hydroxide fine powder, alumina fine powder, magnesium hydroxide fine powder, magnesia fine powder, zinc oxide fine powder, zinc carbonate fine powder; as well as those where the surface has been hydrophobized by surface treatment with an organosilane, silazane, or siloxane oligomer; as well as organic solvents, anti-fungal agents, flame retardants, heat-resistant agents, plasticizers, thixotropic agents, curing accelerators, corrosion inhibitors and migration inhibitors for electrodes and wiring, and the like; and/or pigments such as carbon black, and the like.

### [Method for manufacturing the composition]

The multi-component curable organopolysiloxane composition of the present invention can be prepared by mixing each of the above components, and for the example of liquid (I), by mixing component (A), component (C), and any other optional components. Adjustment is also feasible by mixing component (C) and component (D) as needed, treating the surface of component (C) with component (D), and then mixing component (A).

Liquid (II) can be prepared by mixing component (B), component (C), and component (D), treating the surface of component (C) with component (D), and then mixing component (E), component (F), and if necessary, component (G), and any other optional components.

Although the method for mixing each component may be a conventionally known method and is not particularly limited, a uniform mixture is generally made by simple stirring. Therefore, mixing using a mixing apparatus is preferable. While not particularly limited thereto, exemplary such mixing apparatuses may include a single or twin shaft continuous mixer, two rolls, Ross mixer, Hobart mixer, dental mixer, planetary mixer, kneader mixer, Henschel mixer, etc.

### [Composition form and package]

The multi-component curable organopolysiloxane composition of the present invention is a multi-component curable composition (including a multi-liquid type, in particular a two-liquid type) in which separate components are mixed at the time of use, and a plurality of individually stored compositions can be mixed in a predetermined ratio for use. Note that while not particularly limited thereto, these packages can be selected as desired depending on the curing method, application means, and application object as described below.

### [Curability]

The curable organopolysiloxane composition of the present invention is a condensation reactive and room temperature curable composition, and can be formed in the presence of moisture by a curing reaction mainly involving a condensation reaction with a hydrolysis reaction (in particular, dehydration condensation, deoxime condensation, or dealcohol condensation) at a temperature range of 60°C or less, preferably 50°C or less, and more preferably room temperature (25°C to 50°C). The curing process is not particularly limited, but after mixing each component, curing occurs quickly and deeply in contact with moisture in the air, usually in a temperature range of 15 to 50°C, to form a thermally conductive organopolysiloxane cured product, which is an organopolysiloxane cured reactant with excellent adhesive properties. The cured products have favorable deep curing properties, and demonstrates favorable adhesion properties as compared to the substrate in contact during the curing process, and therefore, it is possible to form a structure with excellent heat dissipation efficiency without creating voids or gaps in the heat-dissipating material.

### [Thermal Conductivity]

The cured organopolysiloxane composition of the present invention can be stably filled with a large amount of thermally conductive filler and provides a thermal conductivity of 2.0 W/mK or higher, preferably 3.5 W/mK or higher, more preferably 4.0 W/mK or more, and particularly preferably 5.0 W/mK. The curable organopolysiloxane compositions of the present invention can provide design compositions and organopolysiloxane cured products with a thermal conductivity of 4.0 to 7.0 W/mK, and can achieve the above-mentioned deep curing and high adhesion to a member/substrate (cured adhesion).

### [Uses and Heat Dissipating Structures]

The curable organopolysiloxane composition of the present invention is useful as a heat transfer material (thermally conductive member) to be interposed at the interface between a thermal boundary surface of a heat-generating component and a heat-dissipating member such as a heat sink or a circuit board for cooling of the heat-generating component by heat conduction, and a heat dissipating structure can be formed with the composition. Although the type, size, and detailed structure of the heat-generating components are not particularly limited, the curable organopolysiloxane composition of the present invention, while having high thermal conductivity, excels in the deep curing properties of the cured material and in the tight fitting properties and gap-filling properties to members, so problems with insufficient curing do not occur. In addition, it has the high tight fitting properties and followability as well as flexibility inherent in silicone materials, which makes it favorable for use in electrical or electronic parts and in heat-dissipating structures for electrical and electronic equipment including cell-type secondary batteries.

Although the structure of such a heat dissipating structure is not particularly limited, an example is a heat dissipation structure with a heat dissipating member provided via a curable organopolysiloxane composition or cured product thereof on a heat dissipating component or a circuit board on which this heat dissipating component is mounted. Examples of such a structure include structures in which an electronic component, which is a heat-dissipating component, is mounted on a circuit board, and heat generated from the electronic component is dissipated by a heat-dissipating member through a thin film layer of the curable organopolysiloxane composition or a cured product thereof, and structures in which these members are arranged in a horizontal direction and a thin film layer of the curable organopolysiloxane composition or a cured product thereof is sandwiched between the circuit board and the heat-dissipating member in a vertical direction. The circuit on the circuit board and the electronic components may be electrically connected, and the circuit board may have via holes formed in order to efficiently transfer heat generated by the electronic components.

In this manner of heat dissipating structure, the curable organopolysiloxane composition or cured product thereof is sandwiched by the circuit board and the heat-dissipating member, and although the thickness thereof is not particularly limited, the thickness can be in the range of 0.1 to 2 mm without falling off, and the heat generated from the electronic components in which the composition is filled without gaps can be efficiently transmitted to the heat-dissipating member.

Electrical and electronic devices equipped with a member made of the curable organopolysiloxane composition are not particularly limited, but include, for example, secondary batteries such as cell-based lithium-ion electrode secondary batteries and cell-stack fuel cells; electronic circuit boards such as printed circuit boards; IC chips packaged with optical semiconductor elements such as diodes (LEDs), organic electric field element (organic EL), laser diodes and LED arrays; CPUs used in electronic devices such as personal computers, digital video disks, mobile phones, and smartphones; LSI chips such as driver ICs and memory; and the like. In particular, in high performance digital switching circuits formed with high integration density, heat removal (heat dissipation) is a major factor in the performance and reliability of the integrated circuits. Thermally conductive members made of the thermally conductive curable organopolysiloxane composition of the present invention or a cured product thereof has superior heat dissipation and handleability when applied to power semiconductor applications, such as engine control, power train systems, and air conditioner control in transportation equipment, and can also achieve superior heat resistance and thermal conductivity when incorporated into in-vehicle electronic components such as electronic control units (ECU) and used in a harsh environment.

In particular, the cured organopolysiloxane composition of the present invention excels in deep curing, curing adhesiveness, and tight fitting properties, and therefore can be suitably placed not only on a horizontal surface but also on an inclined or vertical surface, and can penetrate into a microstructure of heat-generating components such as electrical and electronic components and secondary batteries to provide a heat-dissipating structure without voids (gaps). Therefore, shifting or falling does not readily occur even if placed vertically in a severe temperature environment and thus is suitable as a heat dissipation member and protecting material of automotive control units. In addition, the heat dissipation of electrical and electronic equipment equipped with the heat-dissipating structure can be improved, and problems with latent heat and thermal runaway can be improved. The thermally conductive organopolysiloxane cured material combines flexibility and a certain hardness, and therefore can protect partial structures of electrical and electronic equipment and can improve the reliability and operational stability.

The materials that make up the electrical and electronic devices described above include, for example, resins, ceramics, glass, and metals such as aluminum. The cured organopolysiloxane composition of the present invention can be applied to the base material either as a curable organopolysiloxane composition (fluid) where the components are mixed before curing, or as a thermally conductive organopolysiloxane cured product (cured reactant) after the curing reaction.

### [Curing Method]

With regards to a heat-generating component, the method of forming a heat dissipating structure using the curable organopolysiloxane composition of the present invention is not limited. For example, the curable organopolysiloxane composition of the present invention is injected into a heat-dissipating portion of an electric or electronic component such that gaps are sufficiently filled, and then left at room temperature to cure the composition. The cured organopolysiloxane composition of the present invention has particularly excellent deep curing and curing adhesiveness and tight fitting properties, and therefore can provide an organopolysiloxane cured product with stable thermal conductivity without causing problems of poor curing. This enables the formation of a heat-dissipating structure with excellent heat-dissipating effects and heat-dissipating efficiency, without creating voids between the heat-dissipating members.

The curable organopolysiloxane composition of the present invention is capable of curing in the presence of moisture at a temperature of 60°C or less, preferably in a range of room temperature (25°C) to 50°C, to form a thermally conductive organopolysiloxane cured product, and the conditions required for curing depend on the temperature and humidity, but at a temperature of 25°C and a RH (relative humidity) of about 50%, the time is generally withing a range of several hours to several days. Although the organopolysiloxane cured product may gradually continue to deeply cure in the presence of moisture, the cured organopolysiloxane composition of the present invention cures quickly to a deep depth after mixing the components, and forms a cured product having excellent tight fitting properties and adhesiveness to the heat-dissipating member without causing any problems with poor curing.

The shape, thickness, configuration, and the like of the organopolysiloxane cured product obtained by the above curing can be designed as desired, and may be cured as necessary after filling the gaps of electrical and electronic devices. The composition may be applied or cured on a film provided with a release layer (separator) and handled alone as a sheet-like organopolysiloxane cured product. In such cases, the sheet may be in the form of a thermally conductive sheet reinforced using a known reinforcing material.

### [Specific examples of electrical/electronic equipment]

The cured organopolysiloxane composition of the present invention has sufficient flowability and gap-filling properties for practical use, and forms a thermally conductive member made of organopolysiloxane cured product having excellent adhesiveness, tight fitting properties, flexibility, and thermal conductivity with regard to the heat-dissipating parts, without causing problems of poor curing by deep curing. Therefore, it is also effective for electric and electronic parts with narrow gaps between electrodes, between electric elements and electric elements, between electric elements and packages, and the like, and for those having a structure where it is difficult to follow the expansion and contraction of the organopolysiloxane cured product, such as semiconductor devices like ICs, hybrid ICs, LSIs, and the like, electric circuits and modules in which such semiconductor elements, capacitors, electric resistors, and other electric elements are mounted, various sensors such as pressure sensors, igniters and regulators for automobiles, power generation systems, or power devices for space transportation systems, and the like. In particular, since the organopolysiloxane cured product of the present invention has high deep curing properties and excellent cured tight fitting properties with the heat-dissipating parts, it has an advantage of significantly improving the heat dissipation efficiency of electrical and electronic devices.

### Examples

The present invention will be described below by way of examples; however, the present invention is not limited thereto. In the examples shown below, the following compounds or compositions were used as raw materials.

The components (A) to (G) were mixed in the manner described in each example to obtain the curable organopolysiloxane compositions of Examples 1 to 6 and Comparative Examples 1 to 3. Examples 1-6 relate to thermally conductive, two-component, curable organopolysiloxane compositions, which have room temperature curability.

Thereafter, a frame of 15 mm in height, 100 mm in length, and 50 mm in width was created on a polypropylene sheet using a polyethylene backer, filled with the obtained composition, pressed by a Teflon (registered trademark) sheet on top for smoothing, and cured under an atmosphere of 25°C for one day under these conditions. After curing, the Teflon (registered trademark) sheet and polyethylene backer were removed, and the product was further cured under an atmosphere of 25°C for 6 days to obtain a thermally conductive organopolysiloxane cured product.

The curable organopolysiloxane compositions obtained by the composition parts described in Examples 1 to 6, and Comparative Examples 1 to 3 were blended with component (D) to obtain a thermal conductivity of 3.5 W/mK. This thermal conductivity was measured by the hot disc method using a TPS-500S manufactured by Kyoto Electronics Industry Co., Ltd.

Tests regarding the effects related to the present invention were conducted as follows.

### [Viscosity]

The viscosity (Pa-s) of the curable organopolysiloxane composition at 25°C was measured using a viscometer (Anton Paar Rheocompass MCR102). The geometry was measured using 20 mm diameter parallel plates with a gap of 600 µm and a shear rate of 10.0 (1/s).

### [Evaluation Method For the Usable Time of Curable Organopolysiloxane Compositions]

Individually stored silicone elastomer base composition (Component (I)) and cross-linker composition (component (II)) were blended together and left in the evaluation temperature atmosphere for 24 hours or longer. When the sample was scooped with a metal spatula, the time until viscosity was lost and plasticity appeared was measured and used as the snap time. Evaluation of the usable time was performed at 25°C.

### [Method for Evaluating the Adhesiveness of Curable Organopolysiloxane Composition]

Mixtures of a curable organopolysiloxane composition were sandwiched between two aluminum test panels (anodized aluminum A5052P) at thicknesses of 1 mm and 100 µm, respectively, and allowed to cure by standing at a temperature of 25 ± 2°C and a relative humidity of 50 ± 5%. The tensile shear adhesive strength of the obtained adhesion test pieces was measured in accordance with the method specified in JIS K 6850:1999 "Adhesives-Determination of tensile lap-shear strength of rigid-to-rigid bonded assemblies" after 8 hours and 24 hours, respectively, and recorded as the adhesive strength in Tables 1 to 3.

In the examples shown below, the following compounds or compositions were used as raw materials. The viscosity is a value measured by a rotary viscometer at 25°C.

Component (A):
A-1: Dimethylpolysiloxane with terminals capped by hydroxyl groups (viscosity 420 mPa-s, 85% end ratio, 15% trimethylsiloxy group capped)
A-2: Dimethyl siloxane with one terminal capped with a hydroxyl group and the other terminal capped with a trimethylsiloxy group (viscosity 24 mPa-s)

Component (B):
[(B-1) Component: Organopolysiloxane Having the Following Alkoxysilyl-Containing Groups] 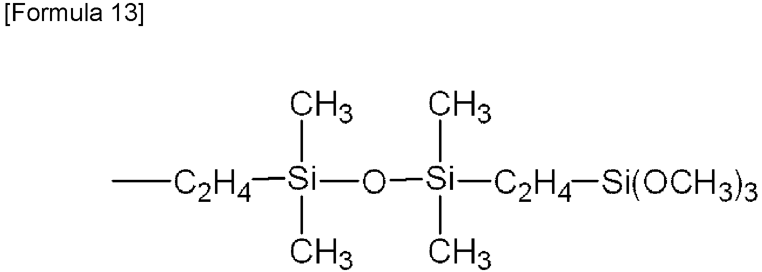
   (b1-1) Polysiloxane modified at both terminals: dimethylpolysiloxane having an alkoxysilyl-containing group at both terminals of a molecular chain (viscosity: 400 mPa-s)
   (b1-2) Siloxane modified by (Vi) on one terminal: dimethylsiloxane, where only one terminal of a molecular chain has an alkoxysilyl-containing group, while the other terminal is capped by a dimethylvinylsiloxy group (viscosity: 400 mPa/s, Vi content 0.04 mass%)
   (b1-3) Polysiloxane with Vi on both terminals: Dimethylsiloxane with both terminals of the molecular chain capped with dimethyvinylsiloxy groups (viscosity 400 mPa-s, Vi content 0.08 mass%)

The components (b1-1) to (b1-3) are mixtures prepared by a hydrosilylation reaction of the following alkoxysilyl-containing siloxane in an amount of 0.8 moles per vinyl group with dimethylvinylsiloxane (viscosity: 400 mPa-s) capped on both ends of the molecular chain with dimethylvinylsiloxy groups in the presence of a hydrosilylation reaction catalyst.

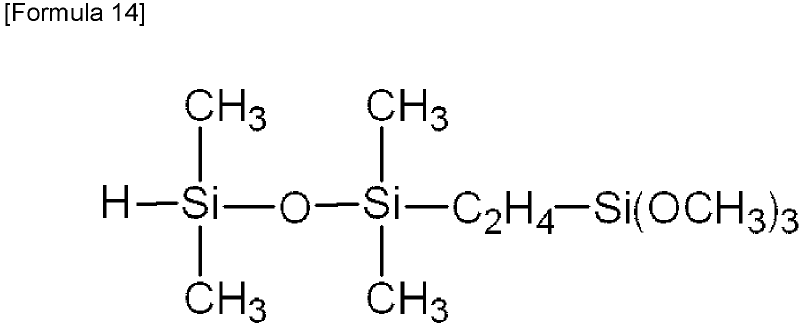

Component (C):
C-1: Crushed aluminum oxide powder with an average particle diameter of 0.4 µm
C-2: Crushed aluminum oxide powder with an average particle diameter of 2.5 µm
C-3: Spherical melted and solidified aluminum oxide powder with an average particle diameter of 35 µm

Component (D):
D-1: Decyltrimethoxysilane

Component (E):
E-1: Decyltrimethoxysilane
E-2: 1,6-bis(trimethoxysilyl) hexane
E-3: Silatrane derivative shown in the following formula (cyclization condensation reaction product of an alkoxysilane having an amino group-containing organic group and an alkoxysilane having an epoxy group-containing organic group)

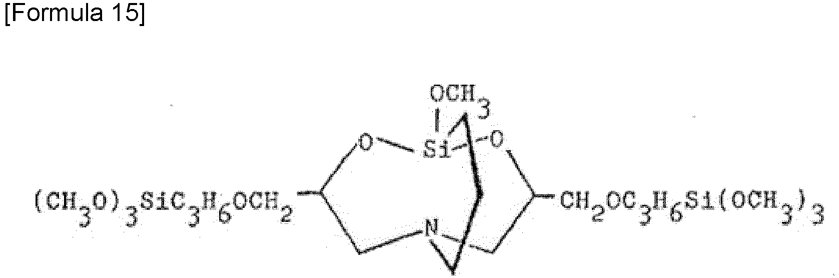

Component (F):
F-1: Dimethyltin dineodecanoate

Component (G):
G-1: N-(2-aminoethyl)3-aminopropyltrimethoxysilane
Pigments: Iron Oxide / Organopolysiloxane Masterbatch

### [Example 1]

90.9 mass parts of component (A-1) and 9.1 mass parts of component (A-2) were weighed, and then 173 mass parts of component (C-1), 191 mass parts of component (C-2), and 464 mass parts of component (C-3) were added sequentially over 60 minutes. After bringing to uniformity, the mixture was mixed under reduced pressure for 30 minutes to obtain liquid (I) of the curable organopolysiloxane composition.

Next, 81.8 mass parts of component (B-1) and 2.9 mass parts of component (D-1) were weighed, and then 173 mass parts of component (C-1), 191 mass parts of component (C-2), and 464 mass parts of component (C-3) were added sequentially over 60 minutes. After homogenization, the mixture was heated and mixed at 160°C for 60 minutes under reduced pressure, and then cooled to room temperature.

To this mixture, 11.8 mass parts of component (E-1), 0.091 mass parts of component (F-1), and 2.3 mass parts of pigment were uniformly mixed to obtain liquid (II) of the curable organopolysiloxane composition.

After curing liquids (I) and (II) of the curable organopolysiloxane composition at 25°C for one day, the viscosity of each liquid was measured with a viscometer (Anton Paar Rheocompass MCR102). After mixing equal masses of liquid (I) and liquid (II), the viscosity, usable time, and adhesiveness were measured.

### [Example 2]

Liquids (I) and (II) of the curable organopolysiloxane composition were obtained in the same manner as Example 1, except that 0.91 mass parts of component (G-1) was added to liquid (II) of the curable organopolysiloxane composition of Example 1, and the viscosity of each liquid was measured. Furthermore, after mixing equal masses of liquid (I) and liquid (II), the viscosity, usable time, and adhesiveness were measured.

### [Example 3]

Liquid (I) and liquid (II) of the curable organopolysiloxane composition were obtained in the same manner as in Example 1, except that component (E-1) of liquid (II) of the curable organopolysiloxane composition of Example 1 was substituted with 11.8 mass parts of component (E-2), and then the viscosity of each liquid was measured. Furthermore, after mixing equal masses of liquid (I) and liquid (II), the viscosity, usable time, and adhesiveness were measured.

### [Example 4]

Liquids (I) and (II) of the curable organopolysiloxane composition were obtained in the same manner as Example 3, except that 0.91 mass parts of component (G-1) was added to liquid (II) of the curable organopolysiloxane composition of Example 3, and the viscosity of each liquid was measured. Furthermore, after mixing equal masses of liquid (I) and liquid (II), the viscosity, usable time, and adhesiveness were measured.

### [Example 5]

Liquid (I) and liquid (II) of the curable organopolysiloxane composition were obtained in the same manner as in Example 1, except that component (E-1) of liquid (II) of the curable organopolysiloxane composition of Example 1 was substituted with 11.8 mass parts of component (E-3), and then the viscosity of each liquid was measured. Furthermore, after mixing equal masses of liquid (I) and liquid (II), the viscosity, usable time, and adhesiveness were measured.

### [Example 6]

Liquids (I) and (II) of the curable organopolysiloxane composition were obtained in the same manner as Example 5, except that 0.91 mass parts of component (G-1) was added to liquid (II) of the curable organopolysiloxane composition of Example 5, and the viscosity of each liquid was measured. Furthermore, after mixing equal masses of liquid (I) and liquid (II), the viscosity, usable time, and adhesiveness were measured.

### [Comparative Example 1]

81.8 mass parts of component (B-1) and 2.9 mass parts of component (D-1) were weighed, and then 173 mass parts of component (C-1), 191 mass parts of component (C-2), and 464 mass parts of component (C-3) were added sequentially over 60 minutes. After homogenization, the mixture was heated and mixed at 160°C for 60 minutes under reduced pressure, and then cooled to room temperature.

To this mixture, 11.8 mass parts of component (E-1), 0.091 mass parts of component (F-1), and 2.3 mass parts of pigment were uniformly mixed to obtain the room temperature curable organopolysiloxane composition.

After curing the curable organopolysiloxane composition at 25°C for 1 day, the viscosity, usable time, and adhesiveness were measured in the same manner as the Examples.

### [Comparative Example 2]

90.9 mass parts of component (A-1) and 9.1 mass parts of component (A-2) were weighed, and then 173 mass parts of component (C-1), 191 mass parts of component (C-2), and 464 mass parts of component (C-3) were added sequentially over 60 minutes. After bringing to uniformity, 11.8 mass parts of component (E-1), 0.091 mass parts of component (F-1), 0.91 mass parts of component (G-1), and 2.3 mass parts of pigments were uniformly mixed into this mixture to obtain a room temperature curable organopolysiloxane composition.

When the room temperature curable organopolysiloxane composition was cured at 25°C for one day, the mixture was already cured and the properties could not be evaluated.

### [Comparative Example 3]

Viscosity, usable time, and adhesiveness were measured in the same manner as in the Examples using SE4485 Thermal Conductive Adhesive, a one-component, room temperature, curable, thermally conductive, silicone composition manufactured by Dow Toray Industries, Inc.

**[Table 1]**

| | | Example 1 | Example 2 | Example 3 | Example 4 | Example 5 | Example 6 |
|---|---|---|---|---|---|---|---|
| Component | | Liquid (I) | Liquid (I) | Liquid (I) | Liquid (I) | Liquid (I) | Liquid (I) |
| A-1 | | 90.9 | 90.9 | 90.9 | 90.9 | 90.9 | 90.9 |
| A-2 | | 9.1 | 9.1 | 9.1 | 9.1 | 9.1 | 9.1 |
| C-1 | | 173 | 173 | 173 | 173 | 173 | 173 |
| C-2 | | 191 | 191 | 191 | 191 | 191 | 191 |
| C-3 | | 464 | 464 | 464 | 464 | 464 | 464 |
| | | Liquid (II) | Liquid (II) | Liquid (II) | Liquid (II) | Liquid (II) | Liquid (II) |
| B-1 | | 81.8 | 81.8 | 81.8 | 81.8 | 81.8 | 81.8 |
| D-1 | | 2.9 | 2.9 | 2.9 | 2.9 | 2.9 | 2.9 |
| C-1 | | 173 | 173 | 173 | 173 | 173 | 173 |
| C-2 | | 191 | 191 | 191 | 191 | 191 | 191 |
| C-3 | | 464 | 464 | 464 | 464 | 464 | 464 |
| E-1 | | 11.8 | 11.8 | | | | |
| E-2 | | | | 11.8 | 11.8 | | |
| E-3 | | | | | | 11.8 | 11.8 |
| F-1 | | 0.091 | 0.091 | 0.091 | 0.091 | 0.091 | 0.091 |
| G-1 | | | 0.91 | | 0.91 | | 0.91 |
| Pigment | | 2.3 | 2.3 | 2.3 | 2.3 | 2.3 | 2.3 |
| Viscosity (Pa-s) | Liquid (I) | 163 | 163 | 163 | 163 | 163 | 163 |
| | Liquid (II) | 82 | 72 | 103 | 88 | 230 | 165 |
| | Liquid (I) and Liquid (II) after mixing | 118 | 171 | 130 | 138 | 138 | 159 |
| Usable life (minutes) | | 120 | 30 | 90 | 30 | 210 | 90 |
| Adhesive strength (MPa) Thickness 100 µm | After 1 day | 0.8 | 0.8 | 0.8 | 0.9 | 0.8 | 0.8 |
| | After 7 days | 1.2 | 2.4 | 2.4 | 1.7 | 2.4 | 2.2 |
| Adhesive strength (MPa) Thickness 1 mm | After 1 day | 0.5 | 0.4 | 0.9 | 0.6 | 1.0 | 0.9 |
| | After 7 days | 0.8 | 1.2 | 1.4 | 1.1 | 1.9 | 1.7 |

**[Table 2]**

| | | Comparative Example 1 | Comparative Example 2 | Comparative Example 3 |
|---|---|---|---|---|
| Component | | | | SE4485 (Commercially available product) |
| A-1 | | | 90.9 | |
| A-2 | | | 9.1 | |
| C-1 | | | 173 | |
| C-2 | | | 191 | |
| C-3 | | | 464 | |
| | | | | |
| B-1 | | 81.8 | | |
| D-1 | | 2.9 | | |
| C-1 | | 173 | | |
| C-2 | | 191 | | |
| C-3 | | 464 | | |
| E-1 | | 11.8 | 11.8 | |
| E-2 | | | | |
| E-3 | | | | |
| F-1 | | 0.091 | 0.091 | |
| G-1 | | 0.91 | 0.91 | |
| Pigment | | 2.3 | | |
| Viscosity (Pa-s) | Liquid (I) | - | - | - |
| | Liquid (II) | - | - | - |
| | Liquid (I) and Liquid (II) after mixing | 72 | Unable to evaluate | 142 |
| Usable life (minutes) | | Uncured | Pre-evaluation curing | 60 |
| Adhesive strength (MPa) Thickness 100 µm | After 1 day | Uncured | Unable to create | Uncured |
| | After 7 days | Uncured | Unable to create | 2.3 |
| Adhesive strength (MPa) Thickness 1 mm | After 1 day | Uncured | Unable to create | Uncured |
| | After 7 days | Uncured | Unable to create | Uncured |

### [Summary]

The two liquid organopolysiloxane compositions according to Examples 1 ~ 6 had sufficient usable life and fluidity after 30 minutes or longer, and can provide an organopolysiloxane cured product with measurable adhesive strength after one day, and a higher adhesive strength after 7 days. As a result, it was confirmed that the compositions according to Examples 1 ~ 6 achieved sufficient deep curability in a relatively short period of time, even when thickly applied, and can achieve high thermal conductivity (3.5 W/mK in the present invention).

In contrast, the one liquid compositions of Comparative Examples 1 ~ 3 could not achieve sufficient usable life (Comparative Example 2), or deep curing and adhesion were insufficient. In particular, when applied at a thickness of 1 mm, an organopolysiloxane cured product having measurable adhesive strength could not be obtained by the method described above even after 7 days (Comparative Example 1 and Comparative Example 3).

## Claims

1. A multicomponent organopolysiloxane composition, comprising:
(A) 100 parts by weight of a diorganopolysiloxane with a molecular terminal blocked by a hydroxysilyl group and a viscosity at 25°C of 20 to 1,000,000 mPa-s;
(B) 50 to 200 parts by mass of a diorganopolysiloxane with a molecular terminal blocked by an alkoxysilyl group and a viscosity at 25°C of 20 to 1,000,000 mPa-s, with regard to 100 parts by mass of component (A);
(C) 400 to 3,500 parts by mass of a thermally conductive filler;
(D) 0.1 to 2.0 mass% of an organic silicon compound serving as a surface treating agent of component (C), with regard to component (C);
(E) one or more types of components selected from alkylalkoxysilanes and the following components (e1) to (e3):
(e1) a reaction mixture between an organoalkoxysilane containing an amino group and an organoalkoxysilane containing an epoxy group;
(e2) an organic compound having at least two alkoxysilyl groups in one molecule, and containing a bond other than a silicon-oxygen bond between the silyl groups; and
(e3) a silane containing an epoxy group as expressed by general formula:
R^{a}ₙSi(OR^{b})₄₋ₙ
(where R^{a} represents an organic group containing a monovalent epoxy group, and R^{b} represents an alkyl group having 1 to 6 carbon atoms, or a hydrogen atom. n represents a number within a range of 1 to 3), or
a partially hydrolyzed condensate thereof; and
(F) a catalytic amount of a condensation-reaction catalyst; wherein
at least the following liquid (I) and liquid (II), which are stored separately, are included.
Liquid (I): A composition containing component (A) and component (C), where component (D) is optionally selectable and does not contain components (B), (E), and (F)
Liquid (II): A composition containing components (B), (C), (D), (E), and (F) and does not contain component (A)

2. The curable organopolysiloxane composition according to claim 1, further comprising (G) an aminoalkylmethoxysilane.

3. The curable organopolysiloxane composition according to any one of claims 1 to 2, wherein at least a portion of component (D) is an alkylalkoxysilane.

4. The curable organopolysiloxane composition according to any one of claims 1 to 3, wherein at least a portion of component (D) and component (E) is an alkylalkoxysilane.

5. The curable organopolysiloxane composition according to any one of claims 1 to 4, which is curable at room temperature and is cured to form a thermally conductive organopolysiloxane cured product.

6. A thermally conductive member, comprising the curable organopolysiloxane composition according to any one of claims 1 to 5 or a cured product thereof.

7. A heat dissipating structure, comprising the thermally conductive member according to claim 6.

8. A heat dissipating structure, comprising a heat dissipating member provided via the curable organopolysiloxane composition according to anyone of claims 1 to 5 or a cured product thereof on a heat dissipating component or a circuit board on which the heat dissipating component is mounted.

9. The heat dissipating structure according to claim 7 or claim 8, which is an electrical or electronic device.

10. The heat dissipating structure according to claim 7 or claim 8, which is an electrical or electronic component or a secondary battery.
